(19) Europäisches Patentamt
European Patent Office
Office européen des brevets

(11) **EP 4 700 402 A1**

(12) **EUROPEAN PATENT APPLICATION**
published in accordance with Art. 153(4) EPC

(43) Date of publication:
**25.02.2026 Bulletin 2026/09**

(21) Application number: **24846068.5**

(22) Date of filing: **25.07.2024**

(51) International Patent Classification (IPC):
*G01R 31/367* (2019.01)   *G01R 31/392* (2019.01)
*G01R 31/36* (2020.01)   *G01R 31/396* (2019.01)

(52) Cooperative Patent Classification (CPC):
**G01R 31/36; G01R 31/367; G01R 31/392;**
**G01R 31/396;** Y02E 60/10

(86) International application number:
**PCT/KR2024/010866**

(87) International publication number:
**WO 2025/023767 (30.01.2025 Gazette 2025/05)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **26.07.2023   KR 20230097583**
**08.07.2024   KR 20240089939**

(71) Applicant: **LG Energy Solution, Ltd.**
**Seoul 07335 (KR)**

(72) Inventors:
• **HWANG, Gyu Yeong**
  **Daejeon 34122 (KR)**
• **KOH, Dong Wook**
  **Daejeon 34122 (KR)**
• **YEOM, In Cheol**
  **Daejeon 34122 (KR)**
• **JUN, Gwang Hoon**
  **Daejeon 34122 (KR)**
• **KIM, You Na**
  **Daejeon 34122 (KR)**

(74) Representative: **Plasseraud IP**
**104 Rue de Richelieu**
**CS92104**
**75080 Paris Cedex 02 (FR)**

(54) **BATTERY STATE PREDICTION DEVICE AND BATTERY STATE PREDICTION METHOD**

(57)    A battery state prediction apparatus according to an embodiment disclosed herein includes a communication interface configured to receive battery data from a battery and at least one process configured to generate a battery state prediction model comprising a first prediction model that predicts a loss of lithium, a second prediction model that predicts a loss of an active material in a cathode, and a third prediction model that predicts a loss of an active material in an anode and input the battery data to the battery state prediction model to obtain battery state data.

FIG.2

**Description**

**[Technical Field]**

CROSS-REFERENCE TO RELATED APPLICATION

This application claims priority to and the benefit of Korean Patent Application No. 10-2023-0097583 filed in the Korean Intellectual Property Office on July 26, 2023, and Korean Patent Application No. 10-2024-0089939 filed in the Korean Intellectual Property Office on July 8, 2024, the entire contents of which are incorporated herein by reference.

TECHNICAL FIELD

Embodiments disclosed herein relate to a battery state prediction apparatus and a battery state prediction method for predicting a state of a battery.

**[Background Art]**

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium-ion battery is attracting attention as a next-generation energy storage medium as a usage range thereof is expanded to a power source of electric vehicles.

A technique for accurately predicting a state of health (SOH) of a battery is very important in terms of safety, performance, lifespan, and economic efficiency of the battery, and environmental protection, and various SOH prediction techniques exist.

However, existing SOH prediction techniques have a limitation in that they predict SOH by considering only a loss of lithium inventory (LLI) of an anode, and thus may not consider additional factors that occur during cycle experiments and actual battery use, rather than storage degradation.

**[Disclosure]**

**[Technical Problem]**

According to an embodiment disclosed herein, a battery state prediction model may be provided which includes a prediction model that describes degradation occurring in a cycle experiment using a pseudo two-dimensional (P2D) model and considers a loss of active material (LAM) in a cathode and an anode during a process of predicting an SOH of a battery.

Technical problems of the embodiments disclosed herein are not limited to the above-described technical problems, and other unmentioned technical problems would be clearly understood by one of ordinary skill in the art from the following description.

**[Technical Solution]**

A battery state prediction apparatus according to an embodiment disclosed herein includes a communication interface configured to receive battery data from a battery and at least one process configured to generate a battery state prediction model including a first prediction model that predicts a loss of lithium, a second prediction model that predicts a loss of an active material in a cathode, and a third prediction model that predicts a loss of an active material in an anode and input the battery data to the battery state prediction model to obtain battery state data.

The at least one processor may be further configured to generate the first prediction model based on an acceleration factor that quantizes a stress applied to an electrode and a solid electrolyte interphase (SEI).

The at least one processor may be further configured to determine a chemical rate change of the active material due to the loss of lithium based on the first prediction model, and determine an open circuit potential (OCP) of the anode and the cathode based on the chemical rate change of the active material.

The at least one processor may be further configured to predict the state of the battery based on a variance of the OCP.

The at least one processor may be further configured to generate the second prediction model based on a cation mixing and a particle cracking induced volume change.

The at least one processor may be further configured to input the battery data to the second prediction model to determine a degradation degree of the battery.

The at least one processor may be further configured to determine a correlation between the loss of lithium and the loss of the active material in the anode and generate the third prediction model based on the correlation.

The at least one processor may be further configured to input a battery capacity change derived by the first prediction model to the second prediction model or the third prediction model to derive a decay factor, and predict the state of the battery based on the decay factor.

A battery state prediction method according to an embodiment includes receiving battery data from a battery, generating a battery state prediction model including a first prediction model that predicts a loss of lithium, a second prediction model that predicts a loss of an active material in a cathode, and a third prediction model that predicts a loss of an active material in an anode, and inputting the battery data to the battery state prediction model to obtain battery state data.

The generating of the first prediction model may include generating the first prediction model based on an acceleration factor that quantizes a stress applied to an electrode and a solid electrolyte interphase (SEI).

The battery state prediction method may further include determining a chemical rate change of the active material due to the loss of lithium based on the first prediction model, and determine an open circuit potential (OCP) of the cathode and the anode based on the chemical rate change of the active material.

The battery state prediction method may further include predicting the state of the battery based on a variance of the OCP.

The generating of the second prediction model may include generating the second prediction model based on a cation mixing and a particle cracking induced volume change.

The battery state prediction method may further include inputting the battery data to the second prediction model to determine a degradation degree of the battery.

The generating of the third prediction model may include determining a correlation between the loss of lithium and the loss of the active material in the anode and generate the third prediction model based on the correlation.

The battery state prediction method may further include inputting a battery capacity change derived by the first prediction model to the second prediction model or the third prediction model to derive a decay factor, and predict the state of the battery based on the decay factor.

**[Advantageous Effects]**

With a battery state prediction apparatus according to an embodiment, degradation tendencies of a cathode and an anode occurring in each operating condition may be predicted through simulation according to an operating condition of a battery.

With the battery state prediction apparatus according to an embodiment, prediction accuracy of SOH diagnosis and remaining useful life (RUL) of the battery may be improved.

With the battery state prediction apparatus according to an embodiment, a voltage of the battery in a middle of life (MoL) of the battery may be diagnosed.

**[Description of Drawings]**

FIG. 1 is a block diagram showing a configuration of a battery state prediction apparatus according to an embodiment.

FIG. 2 schematically shows a flow for a battery state prediction apparatus to predict a state of a battery based on a prediction model, according to an embodiment.

FIG. 3 shows a data analysis result based on a first prediction model of a battery state prediction apparatus, according to an embodiment.

FIG. 4 shows a result of a model considering an acceleration factor and a model not considering an acceleration factor in a battery state prediction apparatus, according to an embodiment.

FIG. 5 shows a correlation graph based on a second prediction model of a battery state prediction apparatus, according to an embodiment.

FIG. 6 shows a data analysis result based on a second prediction model in a battery state prediction apparatus, according to an embodiment.

FIG. 7 shows a result of a model considering a volume change and a model not considering a volume change in a battery state prediction apparatus, according to an embodiment.

FIG. 8 shows a correlation graph based on a third prediction model of a battery state prediction apparatus, according to an embodiment.

FIG. 9 shows a parameter change based on a second prediction model and a third prediction model of a battery state prediction apparatus, according to an embodiment.

FIG. 10 shows a prediction result in storage degradation in a battery state prediction apparatus according to an embodiment.

FIG. 11 shows a prediction result in cycle degradation in a battery state prediction apparatus according to an embodiment.

FIG. 12 is a control flowchart of a battery state prediction method according to an embodiment.

**[Mode for Invention]**

Hereinafter, various embodiments disclosed herein will be described in detail with reference to the accompanying drawings. In this document, identical reference numerals will be used for identical components in the drawings, and the identical components will not be redundantly described.

For various embodiments disclosed herein, specific structural or functional descriptions are only exemplified for the purpose of describing the embodiments, and various embodiments disclosed herein may be implemented in various forms, and should not be construed as being limited to the embodiments described herein.

As used in various embodiments, the terms "1st", "2nd" "first", "second", or the like may modify various components regardless of importance, and do not limit the components. For example, a first component may be named as a second component without departing from the right scope of an embodiment disclosed herein, and similarly, the second component may be named as the first component.

Terms used herein are used for only describing a specific exemplary embodiment and may not have an intention to limit the scope of other exemplary embodiments. It is to be understood that the singular forms include plural references unless the context clearly dictates otherwise.

All terms including technical or scientific terms used herein have the same meaning as commonly understood by those of ordinary skill in the art to which the embodiments disclosed herein belong. It will be further understood that terms, such as those defined in commonly used dictionaries, should be interpreted as having a meaning that is identical to or similar with their meaning in the context of the relevant art and will not be interpreted in an idealized or overly formal sense unless expressly so defined herein. In some cases, the terms defined herein may be interpreted to exclude embodiments disclosed herein.

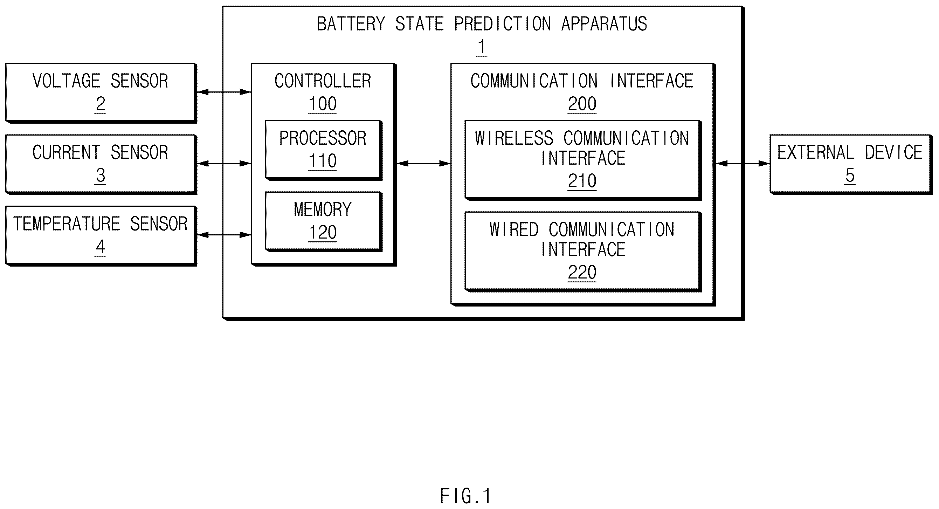

FIG. 1 is a block diagram showing a configuration of a battery state prediction apparatus according to an embodiment.

Referring to FIG. 1, a battery state prediction apparatus 1 according to an embodiment may include a control unit 100 including at least one processor 110 and a memory 120 and a communication interface 200, and may predict a battery state by communicating with an external device 5 through the communication interface 200.

According to an embodiment, the battery state prediction apparatus 1 may monitor voltage, current, temperature, etc., from a voltage sensor 2, a current sensor 3, and a temperature sensor 4 and perform control and management to prevent over-charging, over-discharging, etc., and may include, for example, a battery management system (BMS).

According to an embodiment, the battery state prediction apparatus 1 may include a user terminal and/or a server device capable of communicating with the external device 5.

Specifically, when the battery state prediction apparatus 1 is a user terminal, the controller 100 of the battery state prediction apparatus 1 may include a central processing unit (CPU) of the user terminal such that battery data may be merged on-device in the user terminal. In this case, the user terminal may include, but not limited to, a personal computer (PC), a terminal, a portable telephone, a smart phone, a handheld device, a wearable device, etc.

When the battery state prediction apparatus 1 is a server device, the server device may be implemented with various computing devices such as workstations, clouds, data drives, data stations, etc. The server device may be implemented as one or more server devices physically or logically separated based on a function, a detailed configuration thereof, data, etc., and data may be transmitted and received through communication between server devices and the transmitted and received data may be processed.

The battery state prediction apparatus 1 according to an embodiment may mean any electronic device including the processor 110 and the memory 120, and may be mounted on a vehicle to operate. Hereinbelow, each component of the battery state prediction apparatus 1 may be described in detail.

The communication interface 200 may include a wireless communication interface 210 and a wired communication interface 220 to communicate with the external device 5. The communication interface 200 may transmit and receive a program for feature calculation, class classification, and lifespan estimation for a battery cell or various data, etc., to and from a separately provided external server.

The wireless communication interface 210 may include at least one of a short-range communication module or a long-range communication module.

The short-range communication module may communicate with the external device 5 adjacent to the battery state prediction apparatus 1 by using a short-range communication method. Herein, the short-range communication module may use one communication method among Bluetooth, Bluetooth low energy (BLE), infrared data association (IrDA), Zigbee, WiFi, WiFi Direct, ultra wideband (UWB), or near field communication (NFC).

The long-range communication module may include a communication module that performs various types of long-range communication, and may include a mobile communication interface. The mobile communication interface may transmit and receive a radio signal to and from at least one of a base station, an external terminal, or the external device 5 over a mobile communication network. The long-range communication module may communicate with the external device 5 or other electronic devices, etc., through a nearby access point (AP). The AP may connect a local area network (LAN) to which the battery state prediction apparatus 1 is connected to a wide area network (WAN) to which the communication server is connected. Thus, the battery state prediction apparatus 1 may be connected to the communication server through the external device 5 and the WAN to communicate with each other.

The wired communication interface 220 may access the wired communication network and communicate with the external device 5 through the wired communication network. For example, the wired communication network 220 may access the wired communication network through Ethernet (IEEE 802.3, technical standards), access the wired communication network through CAN communication, and transmit and receive data to and from the external devices 5 through the wired communication network.

The battery state prediction apparatus 1 according to an embodiment may include an input/output interface (not shown). An interface may be provided to allow data to be transmitted and received by connecting an input device (not shown) such as a keyboard, a mouse, a touch panel, etc., an output device such as a display (not shown), etc., and the processor 110.

The memory 120 may store various information required for driving of the battery state prediction apparatus 1. Specifically, the memory 120 may store an operating system and a program required for driving of the battery state prediction apparatus 1 or store data required for driving of the battery state prediction apparatus 1.

Specifically, the memory 120 may store various programs regarding feature calculation, class classification, and lifespan estimation of the battery cell. Moreover, the memory 120 may store various data such as a voltage, a current, feature data, etc., of each battery cell.

The memory 120 may store data regarding a first prediction model, a second prediction model, and a third prediction model to predict a battery state.

The memory 120 may include a volatile memory 120 such as a static random access memory (S-RAM) and a dynamic random access memory (D-RAM) to temporarily memorize data. The memory 120 may also include a non-volatile memory 120 such as a read only memory (ROM), an erasable programmable read only memory (EPROM), and an electrically erasable programmable read only memory (EEPROM), to store data for a long time.

The processor 110 may control in overall the battery state prediction apparatus 1 by outputting a control signal. The processor 110 may include one CPU or graphics processing unit (GPU) or a plurality of CPUs or GPUs. In this case, the processor 110 may be implemented as an array of multiple logic gates, or may be implemented as a combination of the general-purpose microprocessor 110 and the memory 120 storing a program executable on the microprocessor 110.

The memory 120 and the processor 110 may be included in the controller 100 that controls the above-described components to predict a state related to degradation of the battery.

Specifically, the processor 110 may generate a battery state prediction model including the first prediction model, the second prediction model, and the third prediction model, input battery data to the battery state prediction model, and obtain battery state data.

Herein, the first prediction model may include a model for predicting a loss of lithium, and may be defined by an acceleration factor that quantizes a stress applied to an electrode and a solid electrolyte interphase (SEI).

The processor 110 may determine a chemical rate change of an active material due to a lithium loss based on the first prediction model, and determine an open circuit potential (OCP) of a cathode and an anode based on the chemical rate change of the active material.

That is, the first prediction model may describe OCP changes of a cathode and an anode, and thus may accurately analyze physical and chemical changes of the cathode and the anode occurring during degradation of the battery.

The second prediction model may include a model that predicts an active material loss in the cathode, and may be defined by cation mixing and particle cracking induced volume change.

The third prediction model may include a model that predicts an active material loss in the anode, and may be defined by correlation between a lithium loss and an active material loss in the anode.

The processor 110 may input a battery capacity change derived by the first prediction model to the second prediction model or the third prediction model to derive a decay factor. That is, the processor 110 may calculate a change of a capacity predicted in the first prediction model and apply the change to a degradation model of the cathode and the anode to determine decay factors of the cathode and the anode.

As such, the battery state prediction apparatus 1 according to an embodiment may improve the accuracy of degradation degree prediction based on the first prediction model that predicts a lithium loss and the second and third prediction models that predict active material losses in the cathode and the anode.

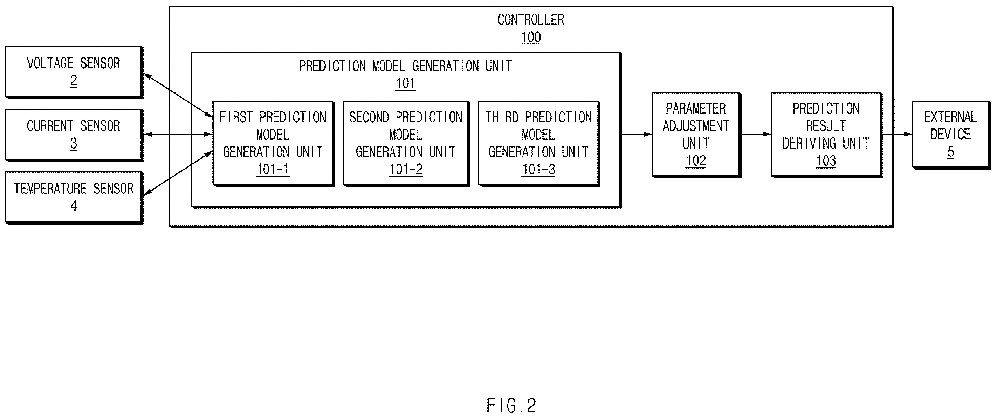

FIG. 2 schematically shows a flow for a battery state prediction apparatus to predict a state of a battery based on a prediction model, according to an embodiment. Components 101 to 103 in FIG. 2 may be implemented in the form of a software block, and may be stored in the memory 120 and executed by the processor 110.

Referring to FIG. 2, the processor 110 may receive battery data through a sensor unit including the voltage sensor 2, the current sensor 3, and the temperature sensor 4. Thereafter, the prediction model generation unit 101 of the controller 100 may generate a plurality of prediction models and determine a degradation degree of the battery.

Specifically, a first prediction model generation unit 101-1 of the controller 100 may generate a prediction model that describes an LLI occurring in a cycle experiment by using a P2D model.

Herein, the P2D model may mean a model that mathematically models an operation of a lithium-ion battery and predicts battery performance by combining a phenomenon at a particle level with a phenomenon at a domain level. Specifically, the P2D model may integrate diffusion and reaction at a fine particle level with a macroscopic transfer phenomenon at the domain level to predict the entire performance of the battery and model a realistic battery operation including porosity of a pole, inhomogeneity of an electrolyte, a polarization effect, etc.

The LLI phenomenon may refer to a phenomenon in which the amount of lithium ions available in the battery decreases, and may occur due to SEI formation, lithium metal plating, electrolyte decomposition, side reactions, etc.

When the LLI phenomenon occurs in the battery, a problem such as capacity reduction, performance degradation, life shortening, etc., may occur, such that the battery performance prediction apparatus according to an embodiment may model the LLI phenomenon occurring in the battery to predict degradation of the battery.

Specifically, the LLI phenomenon occurring in a cycle may be mainly caused by side reactions occurring in the anode and the cathode, and the LLI phenomenon may be expressed as an electrochemical equation in a Butler-Volmer form.

Moreover, due to the stress applied to the anode and the SEI layer, mechanical defects may occur in the electrode and the SEI layer, and surfaces of the anode and the SEI layer may be exposed to an electrolyte due to the defects, such that an SEI may be additionally deposited in a newly derived area. As a result, more LLI may occur than in storage degradation, and merely with a storage degradation model, cycle degradation may not be explained.

With the battery state prediction apparatus 1 according to an embodiment, based on that more stress is generated under low temperature and high C-rate, an acceleration factor may be adopted to simulate cycle degradation.

In this case, it is experimentally difficult to directly calculate the stress applied to the electrode and the SEI layer, in the first prediction model, a concentration difference from the electrode surface to the inside in place of the stress may be expressed as an empirical equation as shown in the equations provided below.

Moreover, in the first prediction model, a mathematical model for describing lithium metal plating occurring in high C-rate and low temperature may also be introduced to simulate abnormal degradation such as abrupt performance degradation due to sharply increasing LLI.

Specifically, Equations 1 to 7 may be included in the first prediction model and may mean an LLI model due to cycle degradation in an anode.

Herein, Equation 1 may mean that in a battery degradation process, a total capacity reduction rate $dQ_{LLIn}/dt$ includes a sum of three main causes, a capacity reduction rate $dQ_{RE}/dt$ related to SEI layer growth, a capacity reduction rate $dQ_{TM}/dt$ related to a transition metal catalytic effect, and a capacity reduction rate $dQ_{LP}/dt$ related to lithium metal plating.

Specifically, in Equation 2, $f_{ACC}(C_s(t))$ may mean an acceleration factor with respect to a charging state, A may mean an electrode plate area of a battery, $L_n$ may mean a thickness or length of an electrode, $a_n$ may mean a coefficient related to an activation material of the battery, and $i_{RE}$ may mean current related to growth of an SEI layer.

In Equation 3, $f_{ACC}(C_s(t))$ may mean an acceleration factor with respect to a charging state, A may mean an electrode plate area of a battery, $L_n$ may mean a thickness or length of an electrode, $a_n$ may mean a coefficient related to an activation material of the battery, and $i_{TM}$ may mean current related to the transition metal catalytic effect.

In Equation 4, A may mean an electrode plate area of a battery, $L_n$ may mean a thickness or length of an electrode, $a_n$ may mean a coefficient related to an activation material of the battery, and $i_{LP}$ may mean current related to lithium plating.

In Equation 5, $i_{RE}$ may mean current related to SEI layer growth, $f_{RE}$ may mean a function for determining SEI layer growth current, $z_{(n,surf)}(t)$ may mean an electrode surface concentration with respect to time t, $U_n(t)$ may mean an electrode potential with respect to a time, and $T(t)$ may mean a temperature with respect to a time.

In Equation 6, $i_{TM}$ may mean current related to the transition metal catalytic effect, $f_{TM}$ may mean a function for determining the current related to the transition metal catalytic effect, $U_p(t)$ may mean an electrode voltage with respect to a time, and $T(t)$ may a temperature with respect to a time.

In Equation 7, $i_{LP}$ may mean current related to lithium plating, $f_{RE}$ may mean a function for determining lithium plating current, $U_n(t)$ may mean an electrode potential with respect to a time, and $T(t)$ may mean a temperature with respect

to a time.

**【Equation 1】**

$$dQ_{LLI_n}/dt = dQ_{RE}/dt + dQ_{TM}/dt + dQ_{LP}/dt$$

**【Equation 2】**

$$dQ_{RE}/dt = f_{ACC}(C_s(t)) * A * L_n * a_n * i_{RE}$$

**【Equation 3】**

$$dQ_{TM}/dt = f_{ACC}(C_s(t)) * A * L_n * a_n * i_{TM}$$

**【Equation 4】**

$$dQ_{LP}/dt = A * L_n * a_n * i_{LP}$$

**[Equation 5]**

$$i_{RE} = f_{RE}(z_{(n,surf)}(t), U_n(t), T(t))$$

**[Equation 6]**

$$i_{TM} = f_{TM}(U_P(t), T(t))$$

**[Equation 7]**

$$i_{LP} = f_{RE}(U_n(t), j_n(t), T(t))$$

Equations 8 to 10 may be included in the first prediction model and may mean an LLI model due to cycle degradation in a cathode.

Specifically, in Equation 8, $dQ_{LLI_p}/dt$ may mean a capacity reduction rate related to lithium loss, and $dQ_{CEI}/dt$ may mean a capacity reduction rate related to CEI formation. Herein, CEI may mean an interfacial layer formed between a cathode and an electrolyte in a lithium-ion battery.

In Equation 9, $dQ_{CEI}/dt$ may mean a capacity reduction rate related to CEI formation, A may mean an electrode plate area, $L_P$ may mean a thickness or length of an electrode, $a_P$ may mean a specific surface area of an electrode active material, and $i_{CEI}$ may mean current related to CEI formation.

In Equation 10, $i_{CEI}$ may mean current related to CEI formation, $f_{CEI}$ may mean a function for determining CEI formation current, $U_p(t)$ may mean an electrode voltage with respect to a time, and T(t) may mean a temperature with respect to a time.

**[Equation 8]**

$$dQ_{LLI_p}/dt = dQ_{CEI}/dt$$

**[Equation 9]**

$$dQ_{CEI}/dt = A * L_p * a_p * i_{CEI}$$

[Equation 10]

$$i_{CEI} = f_{CEI}(U_P(t), T(t))$$

A second prediction model generation unit 101-2 of the controller 100 may model degradation in the cathode based on correlation between a loss of an active material of a cathode (LAMp) and a state of charge (SOC) in battery storage and cycle degradation.

Specifically, LAMp may mean an active material loss in the cathode, and may mean, as one of main causes for battery performance degradation, that an active material of the cathode is lost or deactivated in charging and discharging of the battery.

The second prediction mode may include a pseudo cation mixing that simulates a phenomenon in which a cation in an electrode exchanges a position thereof with that of another cation in an electrode material and a particle cracking induced volume change model that simulates a cracking phenomenon occurring as electrode particles repetitively expand or shrink.

The pseudo cation mixing model included in the second prediction model establishes a degradation model assuming pseudo cation mixing, thereby describing degradation in the cathode occurring frequently in an intermediate SOC region (50 to 60 %).

Specifically, in a low SOC region, nickel ions (Ni2+) in an NCM crystalline structure easily moves to lithium ions (Li+), but due to fewer lithium ion vacancies, less cation mixing may occur.

On the other hand, in a high SOC region, as the nickel ions (Ni2+) are oxidized to nickel ions (Ni4+), movement to the lithium ions (Li+) may become difficult to make, and in spite of many lithium ion vacancies, less antisite defects may occur.

Based on such a feature, the second prediction model of the battery state prediction apparatus 1 according to an embodiment may include a cation mixing governing equation as shown in Equations 11 and 12 provided below.

Specifically, in Equation 11, $dQ_{CM}/dt$ may mean a capacity reduction rate due to cation mixing, $i_{CM}$ may mean current related to cation mixing, A may mean an electrode plate area, $L_P$ may mean a thickness or length of an electrode, and $a_P$ may mean a specific surface area of an electrode active material.

In Equation 12, $i_{CM}$ may mean current related to cation mixing, $f_{CM}$ may mean a function for determining current related to cation mixing, $NI_{Li}(t)$ may mean lithium concentration with respect to a time, and T(t) may mean a temperature with respect to a time.

[Equation 11]

$$dQ_{CM}/dt = i_{CM} * A * L_p * a_p$$

[Equation 12]

$$i_{CM} = f_{CM}(NI_{Li}(t), T(t))$$

Moreover, the particle cracking induced volume change model included in the second prediction model may assume particle cracking due to volume change to establish a degradation model, thereby describing additional cathode degradation occurring in a cycle.

Specifically, the particle cracking induced volume change model may be generated assuming that when current is applied to a battery, a volume of a cathode decreases in charging and thus delithiation with respect to the cathode may occur, and cracking may occur between initial particles and an electrolyte may penetrate into an extra space caused by the cracking, leading to degradation of the cathode.

Based on such a feature, the second prediction model of the battery state prediction apparatus 1 according to an embodiment may include a particle cracking governing equation as shown in Equations 13 and 14 provided below.

Specifically, in Equation 13, $dQ_{CR}/dt$ may mean a capacity reduction rate due to volume change based on particle cracking, $i_{CR}$ may mean current related to particle cracking, A may mean an electrode plate area, $L_P$ may mean a thickness or length of an electrode, and $a_P$ may mean a specific surface area of an electrode active material.

In Equation 14, $i_{CR}$ may mean current related to particle cracking, $f_{CR}$ may mean a function for determining current related to particle cracking, $\Delta V(t)$ may mean a volume change with respect to a time, and T(t) may mean a temperature with respect to a time.

**【Equation 13】**

$$dQ_{CR}/dt = i_{CR} * A * L_p * a_p$$

**【Equation 14】**

$$i_{CR} = f_{CR}(\Delta V(t), T(t))$$

The third prediction model generation unit 101-3 of the controller 100 may model degradation in the anode based on correlation between an LLI and a loss of an active material of an anode (LAMn) in battery storage and cycle degradation.

Specifically, LAMn may mean an active material loss in the anode, and may mean, as one of main causes for battery performance degradation, that an active material of the anode is lost or deactivated in charging and discharging of the battery.

The battery state prediction apparatus 1 according to an embodiment assumes that pore clogging due to an LLI blocks a surface site of the anode to which lithium may be introduced, leading to the LAMn, and the third prediction model may be configured as in Equation 15.

Specifically, in Equation 15, $Q_{LAM_n}$ may mean an active material loss of a cathode, $f_{LAM_n}$ may mean a function for determining the active material loss of the cathode, and $Q_{LLI}$ may mean an LLI.

**【Equation 15】**

$$Q_{LAM_n} = f_{LAM_n}(Q_{LLI})$$

Thereafter, a parameter adjustment unit 102 of the controller 100 may simulate a parameter change of a physical model with respect to an LLI and a parameter change of a physical model with respect to an LAM.

Specifically, for a parameter change of a physical model with respect to an LLI, an LLI may be applied to Equations 16 to 20 and a voltage use region (Vmax, Vmin) may be defined to mathematically calculate a change of a stoichiometry use area (w0 to w100 for anodes, z0 to z100 for cathodes) of the cathodes and the anodes based on the LLI.

Thus, a corresponding result may be reflected to the physical model to describe an OCP change of the cathode and the anode with respect to the LLI.

Specifically, in Equation 16, $\omega_O$ may mean a stoichiometry value of an anode in an initial state, $\gamma_n$ may mean a maximum capacity of the anode, $z_O$ may mean a stoichiometry of a cathode in the initial state, $\gamma_P$ may mean a maximum capacity of the cathode, $Q_{tot}$ may mean a total capacity of a battery, and $Q_{ion,loss}$ may mean a capacity loss with respect to a loss of ions.

In Equation 17, $\omega_{100}$ may mean a stoichiometry value of the anode in a final state, and $z_{100}$ may mean a stoichiometry value of the cathode in the final state. $\gamma_n$ may mean a maximum capacity of the anode, $\gamma_P$ may mean a maximum capacity of the cathode, $Q_{tot}$ may mean a total capacity of a battery, and $Q_{ion,loss}$ may mean a capacity loss with respect to a loss of ions.

In Equation 18, $U_P(z_0)$ may mean a cathode potential in the initial state, $U_n(\omega_0)$ may mean an anode potential in the initial state, and $V_{min}$ may mean a minimum operating voltage of a battery.

In Equation 19, $U_P(z_{100})$ may mean a cathode potential in the final state, $U_n(\omega_{100})$ may mean an anode potential in the final state, and $V_{max}$ may mean a maximum operating voltage of the battery.

In Equation 20, $Q_{tot}$ may indicate a total capacity of the battery, and Equation 20 may mean that the total capacity of the battery is expressed as a product of a change of a stoichiometry value of the anode and the cathode and their maximum capacities.

**【Equation 16】**

$$\omega_0 \gamma_n + z_0 \gamma_P = Q_{tot} Q_{ion,loss}$$

**【Equation 17】**

$$\omega_{100} \gamma_n + z_{100} \gamma_P = Q_{tot} Q_{ion,loss}$$

【Equation 18】

$$U_P(z_0)-U_n(\omega_0)=V_{\min}$$

【Equation 19】

$$U_P(z_{100})-U_n(\omega_{100})=V_{\max}$$

【Equation 20】

$$Q_{tot}=(\omega_{100\text{-}}\omega_0)\gamma_n=(z_{0\text{-}}z_{100})\gamma_P$$

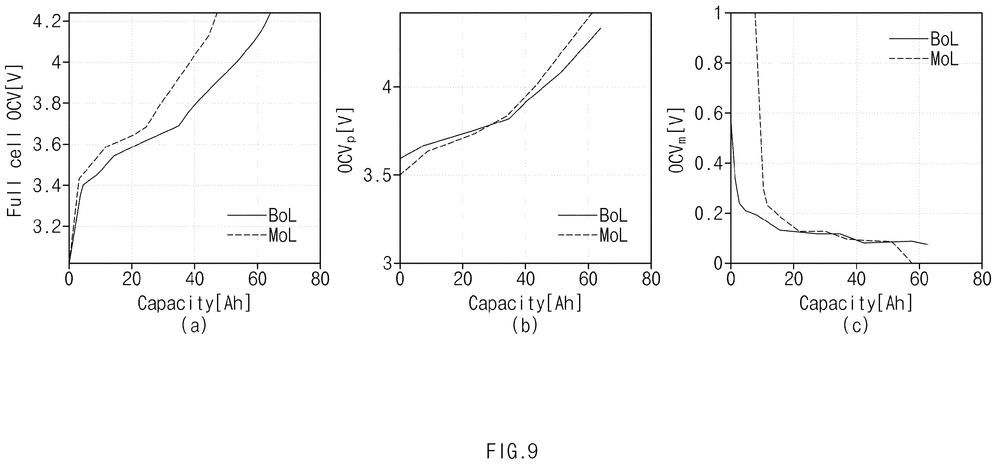

For a parameter change of a physical model with respect to an LAM, as the LAM occurs, shrinkage of an OCP profile of the anode and the cathode may occur and the LAM may be a main cause for an OCV profile change. By introducing a decay factor, a parameter change with respect to an LAM may be simulated, which will be described in detail with reference to FIG. 9.

Thereafter, a prediction result deriving unit 103 of the controller 100 may predict a state of the battery considering a degradation degree of the battery from at least one of the first prediction model, the second prediction model, and the third prediction model, and transmit the predicted state to the external device 5.

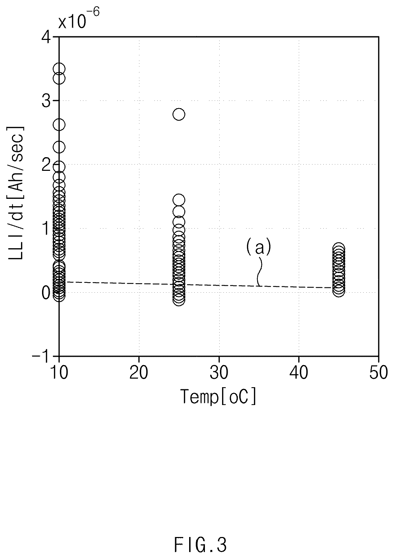

FIG. 3 shows a data analysis result based on a first prediction model of a battery state prediction apparatus, according to an embodiment.

Referring to FIG. 3, it may be seen as indicated by a virtual trend line (a) that an LLI occurs significantly at low temperatures in cycle degradation, and the battery state prediction apparatus 1 according to an embodiment may predict the state of the battery by considering the LLI occurring significantly at low temperatures. In FIG. 3, a horizontal axis may mean a temperature of the battery and a vertical axis may mean a reduced amount of a capacity of the battery.

Specifically, an LLI occurring significantly at low temperatures may be caused due to SEI formation increase, lithium precipitation, electrolyte performance degradation, etc.

Regarding SEI formation as one of causes for LLI increase, SEI formation on an electrode surface may increase at low temperatures and an SEI layer is a solid layer formed on the electrode surface by reaction between lithium ions and an electrolyte, such that in this process, the lithium ions may be consumed and the amount of available lithium ions may be reduced.

SEI formation may mainly occur during an initial cycle of the battery, but this process may be further actively performed at low temperatures, and as a result of the process, the SEI layer may be thickened and more lithium ions may be clogged, affecting battery degradation.

Regarding lithium precipitation as one of the causes for LLI increase, lithium ions may not be uniformly inserted into an anode at low temperatures and may be highly likely to be precipitated in the form of lithium metal, and the lithium metal may not be reused, increasing an LLI.

Regarding electrolyte performance degradation as one of the causes for LLI increase, ion conductivity of the electrolyte may decrease at low temperatures and the moving speed of the lithium ions may decrease, increasing an internal resistance of the battery. As a result, electrolyte performance degradation may cause nonuniform lithium ions exchanging with an electrode, increasing an LLI.

The battery state prediction apparatus according to an embodiment may introduce, as in Equations 1 to 10, a mathematical model for describing lithium plating occurring in high C-rate and low temperature to simulate abnormal degradation such as abrupt performance degradation due to sharply increasing LLI.

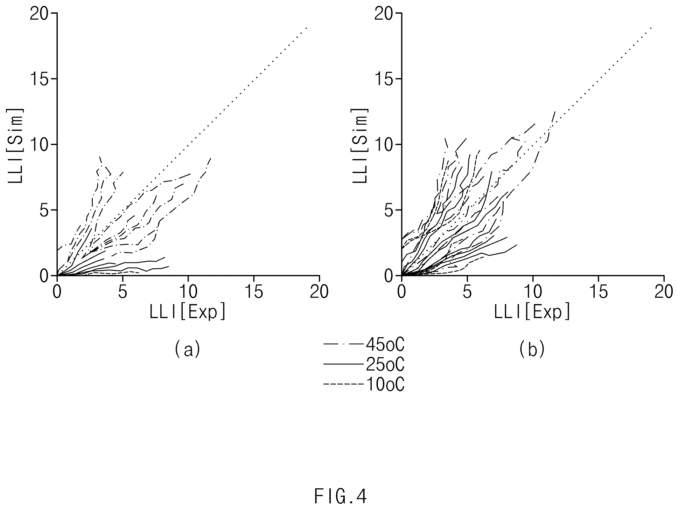

FIG. 4 shows a result of a model considering an acceleration factor and a model not considering an acceleration factor in a battery state prediction apparatus, according to an embodiment. In FIG. 4, a horizontal axis may mean a predicted value of an LLI and a vertical axis may mean a simulated value of the LLI.

Referring to FIG. 4, it may be seen that the predicted value of the LLI predicted by the processor 110 of the battery state prediction apparatus 1 according to an embodiment shows a linear relationship with the simulated value.

Specifically, (a) of FIG. 4 may mean the first prediction model when the acceleration factor is not considered, and (b) of FIG. 4 may mean the first prediction model when the acceleration factor is considered as in Equations 1 to 10.

In (a) of FIG. 4, a first training model may not consider an acceleration factor that quantizes stress applied to an anode and an SEI, such that a graph may be expressed relatively far from a trend line of a linear relationship at every temperature.

On the other hand, in (b) of FIG. 4, the first training model may consider the acceleration factor that quantizes the stress applied to an anode and an SEI as an equation, such that a graph may be expressed relatively close to the trend line of the linear relationship at every temperature.

That is, when the predicted value and the simulated value of the LLI show a linear relationship, it may mean that a prediction model accurately reflects an LLI change and the first prediction model implements an operation of an actual battery system well.

As a result of experiment with application or non-application of the acceleration factor under the same conditions, a root mean square error (RMSE) is 1.97 Ah in (a) of FIG. 4, and an RMSE is 1.38 Ah in (b) of FIG. 4, such that it may be seen that prediction performance to which the acceleration factor is applied in (b) of FIG. 4 is superior even based on the RMSE that measures a difference between the predicted value and the simulated value of the model.

As a result, the battery state prediction apparatus 1 according to an embodiment may introduce the acceleration factor unlike in conventional arts to quantize stress applied to an electrode and an SEI, thereby improving the capability of simulating degradation of the actual battery system.

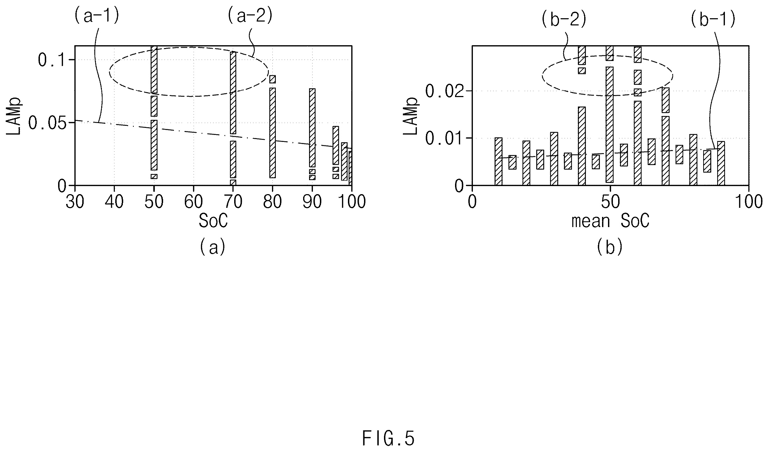

FIG. 5 shows a correlation graph based on a second prediction model of a battery state prediction apparatus, according to an embodiment.

(a) of FIG. 5 means a correlation between an LAMp and an SOC in relation to storage degradation in a second prediction model, and (b) of FIG. 5 means a correlation between an LAMp and an SOC in relation to cycle degradation in the second prediction model.

Specifically, in a low SOC region of FIG. 5, nickel ions (Ni2+) in an NCM crystalline structure easily moves to lithium ions (Li+), but due to fewer lithium ion vacancies, less cation mixing may occur.

On the other hand, in a high SOC region, as the nickel ions (Ni2+) are oxidized to nickel ions (Ni4+), movement to the lithium ions (Li+) may become difficult to make, and in spite of many lithium ion vacancies, less antisite defects may occur.

As such, identification may be difficult to achieve with trend lines (a-1) and (b-1), but lithium vacancies and movement of nickel ions with respect to a charging state may have a trade-off relationship, a volcano-type trend may occur in which an LAMp occurs significantly in a middle SOC region, such as regions (a-2) and (b-2).

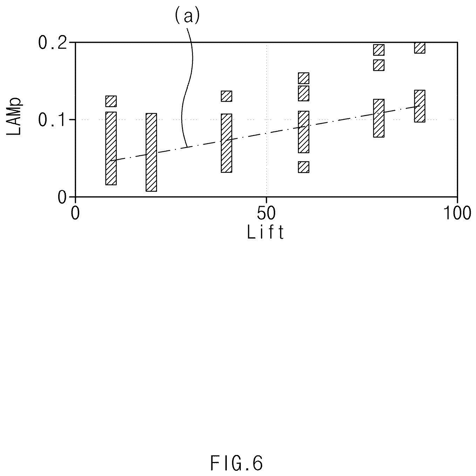

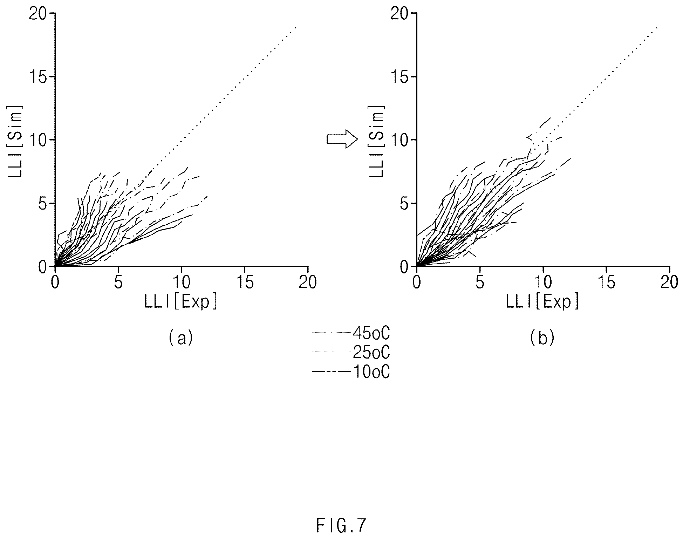

Thus, the battery state prediction apparatus 1 according to an embodiment may simulate an LAMp occurring significantly in the middle SOC region in FIGS. 6 and 7.

FIG. 6 shows a data analysis result based on a second prediction model in a battery state prediction apparatus, according to an embodiment.

Referring to FIG. 6, it may be seen as indicated by a virtual trend line (a) that an LAMp occurs significantly when a lift of an SOC is large, and the battery state prediction apparatus 1 according to an embodiment may predict the state of the battery by considering the LAMp occurring when the life of the SOC is large. In FIG. 3, a horizontal axis may mean a size of a lift of an SOC and a vertical axis may mean a size of an LAMp.

Specifically, when a lift of an SOC is large in cycle degradation, that is, when the SOC is maintained for a longer time in a high SOC state or charging is performed frequently with a high SOC, the loss of the active material in the cathode may occur due to complex factors such as electrolyte decomposition, corrosion of a cathode material, thermal instability, mechanical stress, SEI layer formation on the electrode surface, etc.

In this regard, the battery state prediction apparatus 1 according to an embodiment may precisely predict the LAMp based on the pseudo cation mixing model and the particle cracking induced volume change model as in Equations 11 to 14.

FIG. 7 shows a result of a model considering a volume change and a model not considering a volume change in a battery state prediction apparatus, according to an embodiment.

Referring to FIG. 7, it may be seen that the predicted value of the LAMp predicted by the processor 110 of the battery state prediction apparatus 1 according to an embodiment shows a linear relationship with the simulated value.

Specifically, (a) of FIG. 7 means a prediction result graph when the processor 110 applies the pseudo cation mixing model of the second prediction model, and (b) of FIG. 7 means a prediction result graph when both the pseudo cation mixing model and the particle cracking induced volume change model are applied.

In (a) of FIG. 7, a second training model may not consider a particle cracking induced volume change, such that a graph may be expressed relatively far from a trend line of a linear relationship at every temperature.

On the other hand, in (b) of FIG. 7, the second training model may consider the anode and the particle cracking induced volume change as Equations 13 and 14, such that a graph may be expressed relatively close to the trend line of the linear relationship at every temperature.

That is, when the predicted value and the simulated value of the LAMp show a linear relationship, it may mean that a prediction model accurately reflects an LAMp change and the second prediction model implements an operation of an actual battery system well.

As a result of experiment with application or non-application of the particle cracking induced volume change under the same conditions, an RMSE is 1.63 Ah in (a) of FIG. 7, and an RMSE is 1.28 Ah in (b) of FIG. 7, such that it may be seen that prediction performance to which the particle cracking induced volume change is applied in (b) of FIG. 7 is superior even based on the RMSE that measures a difference between the predicted value and the simulated value of the model.

As a result, the battery state prediction apparatus 1 according to an embodiment may predict the LAMp by considering both the pseudo cation mixing model and the particle cracking induced volume change model as in Equation 21 provided below, thereby improving the capability of simulating degradation of the actual battery system.

Specifically, in Equation 21, $dQ_{LAMp}/dt$ may mean a capacity reduction rate due to a loss of an active material of a cathode, $dQ_{CM}/dt$ may mean a capacity reduction rate due to cation mixing, and $dQ_{CR}/dt$ may mean a capacity reduction rate due to a particle cracking induced volume change. Thus, the loss of the active material of the cathode may be expressed as a sum of capacity reduction rates occurring due to cation mixing (CM) and a particle cracking induced volume change (CR).

【Equation 21】

$$dQ_{LAM_p}/dt = dQ_{CM}/dt + dQ_{CR}/dt$$

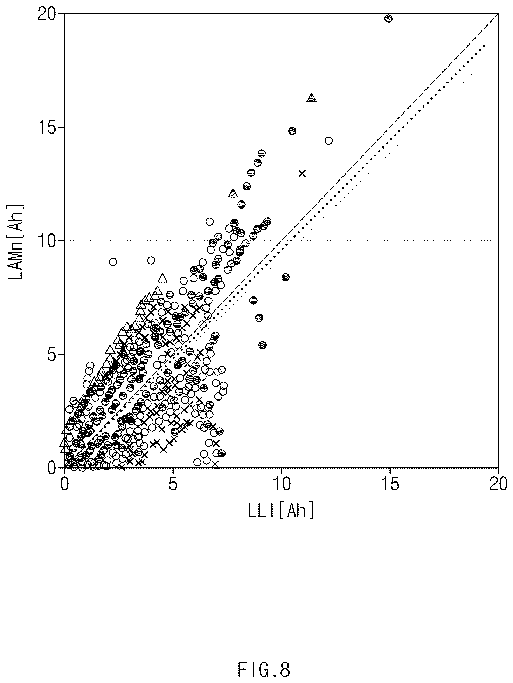

FIG. 8 shows a correlation graph based on a third prediction model of a battery state prediction apparatus, according to an embodiment.

Referring to FIG. 8, the processor 110 may analyze a correlation between an LLI and an LAMn that is a loss of an active material in an anode, and based thereon, a trend having a linear relationship may be seen as shown in FIG. 8.

Specifically, a cause for the correlation is that when an SEI layer is formed on an anode surface, lithium ions may be consumed and more lithium ions may be irreversibly consumed as the SEI layer is thickened, increasing an LLI. In this case, when the SEI layer is thickened, an active surface of the anode decreases, causing an LAMn, such that they are correlated with each other.

Moreover, during repetitive charging/discharging cycles, as an anode material expands and shrinks, mechanical stress occurs, causing decomposition and cracking of the anode material and thus increasing the LAMn. Moreover, as the loss of the anode material increases, the capability of accommodating lithium ions may be reduced, worsening an LLI.

In addition, in a high-SOC and low-temperature environment, lithium ions may not be uniformly inserted into an anode and may be highly likely to be precipitated in the form of lithium metal, increasing an LLI, and the precipitation of the lithium metal may damage the anode surface, worsening an LAMn.

From such a correlation, the processor 110 may assume that pore clogging due to an LLI blocks a surface site of the anode to which lithium may be introduced, leading to the LAMn, and thus the state of the battery may be predicted using the model as in Equation 15.

FIG. 9 shows a parameter change based on a second prediction model and a third prediction model of a battery state prediction apparatus, according to an embodiment.

Referring to FIG. 9, in the second prediction model and the third prediction model, a parameter change of a physical model with respect to an LAM may be simulated. Specifically, as the LAM occurs, shrinkage of an OCP profile of the anode and the cathode may occur and the LAM may be a main cause for an OCV profile change. In this way, the processor 110 may simulate a parameter change with respect to an LAM by introducing a decay factor.

It may be assumed that (a) of FIG. 9 shows a graph profile of an OCV (a vertical axis) with respect to a capacity (a horizontal axis) when an LAM does not occur, (b) of FIG. 9 shows a changed graph profile when an LAMp of 20 % occurs, and (c) of FIG. 9 shows a graph profile changed when an LAMn of 30 % occurs.

To simulate a change of the graph profiles, a decay factor may be introduced, and to simulate a parameter change with respect to an LAM by introducing the decay factor, a capacity of the battery may be calculated as in Equation 22 from design information.

Specifically, in Equation 22, Q may mean a capacity of a battery, $stoi_0$-$stoi_{100}$ may mean a result of subtracting a final stoichiometry value from an initial stoichiometry value, $\varepsilon_s$ may mean a volume ratio of an active material in a charging state of an electrode, L may mean a thickness or a length of the electrode, A may mean an area of the electrode, F may mean a constant like a Faraday constant, and $C_{max}$ may mean a maximum concentration.

【Equation 22】

$$Q = (stoi_0 - stoi_{100}) * \varepsilon_s * L * A * F * C_{max}$$

The shrinkage of an open circuit voltage (OCV) when the LAM occurs may be interpreted as maintaining the use range of stoichiometry (z), but changing stoichiometry over time.

The LAM may be reflected by reducing a maximum concentration C_max or reducing a volume fraction epss with respect to the LAM occurring from the foregoing capacity relational expression.

For example, i) when C_max decreases, z may increase with respect to the same surface concentration when compared to an initial state BoL from a relational expression of z=C_surf(t)/C_max. In addition, ii) when the volume fraction decreases, an electrochemical specific surface area decreases, such that a density of current flowing through electrode particles may increase even when the same current as the initial state is applied. This results in increasing a variance of the stoichiometry.

For a cathode, an LAMp due to cation mixing is assumed to be a main cause for degradation to assume that a change of a crystalline structure due to cation mixing leads to a change of a theoretical capacity of an electrode particle, thereby adjusting the maximum concentration C_max among parameters of the physical model.

For an anode, an LAMn is assumed to occur due to pore clogging caused by an LLI to assume that an electrochemical specific surface area decreases when compared to in terms of one particle, thereby adjusting a volume fraction.

By calculating and applying a change of a capacity as in Equation 22 together with the aforementioned assumptions, decay factors for the cathode and the anode may be defined as in Equations 23 to 26.

Specifically, in Equation 23, $decay_n$ may mean a decay factor of the anode, $Q_{MoL}/Q_{BoL}$ may mean a value obtained by dividing the capacity in the middle of the life by the initial capacity, $stoi_{n_{100_{BoL}}} - stoi_{n_{0_{BoL}}}$ may mean a value obtained by subtracting the initial stoichiometry from the final stoichiometry of the anode in the initial state, and $stoi_{n_{100_{MoL}}} - stoi_{n_{0_{MoL}}}$ may mean a value obtained by subtracting the initial stoichiometry from the final stoichiometry of the anode in the middle of the life.

In Equation 24, $decay_p$ may mean a decay factor of the cathode, $Q_{MoL}/Q_{Bol}$ may mean a value obtained by dividing the capacity in the middle of the life by the initial capacity, $stoi_{p_{100_{Bol}}} - stoi_{p_{0_{Bol}}}$ may mean a value obtained by subtracting the initial stoichiometry from the final stoichiometry of the cathode in the initial state, and $stoi_{p_{100_{Mol}}} - stoi_{p_{0_{Mol}}}$ may mean a value obtained by subtracting the initial stoichiometry from the final stoichiometry of the cathode in the middle of the life.

In Equation 25, $\varepsilon_{s_n}$ may mean a volume rate of an active material of the anode in the current state, $\varepsilon_{s_{n\_BoL}}$ may mean a volume rate of an active material of the anode in the initial state, and $decay_n$ may mean a decay factor of the anode.

In Equation 26, $C_{max\_p}$ may mean a volume rate of an active material of the cathode in the current state, $C_{max\_p\_BoL}$ may mean a volume rate of an active material of the cathode in the initial state, and $decay_P$ may mean a decay factor of the cathode.

【Equation 23】

$$decay_n = Q_{MoL}/Q_{BoL} \circ (stoi_{n_{100_{BoL}}} - stoi_{n_{0_{BoL}}})/(stoi_{n_{100_{MoL}}} - stoi_{n_{0_{MoL}}})$$

【Equation 24】

$$decay_n = Q_{MoL}/Q_{BoL} \circ (stoi_{p_{100_{BoL}}} - stoi_{p_{0_{BoL}}})/(stoi_{p_{100_{MoL}}} - stoi_{p_{0_{MoL}}})$$

【Equation 25】

$$\varepsilon_{s_n} = \varepsilon_{s_{n\_BoL}} \circ decay_n$$

【Equation 26】

$$C_{max\_p} = C_{max\_p\_BoL} \circ decay_p$$

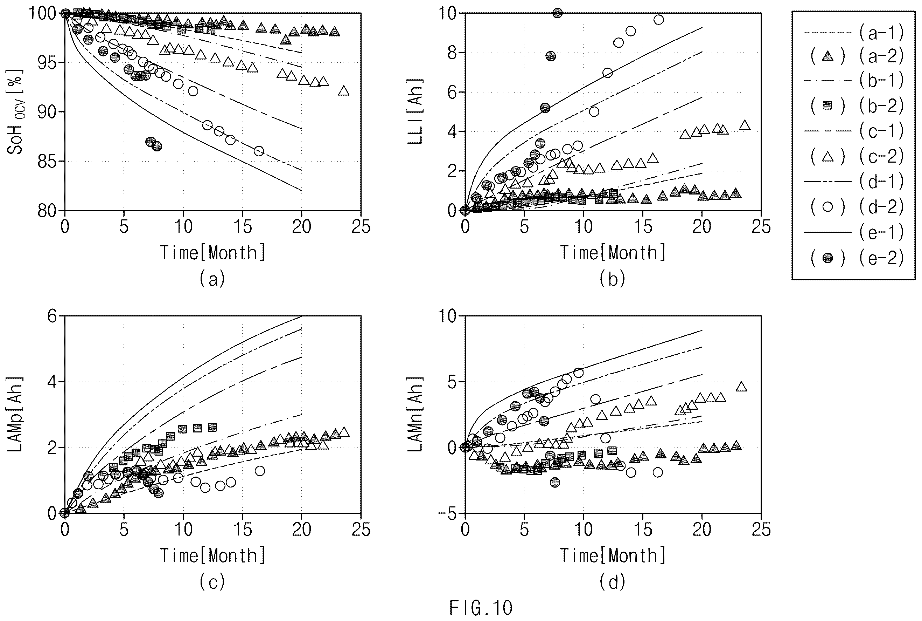

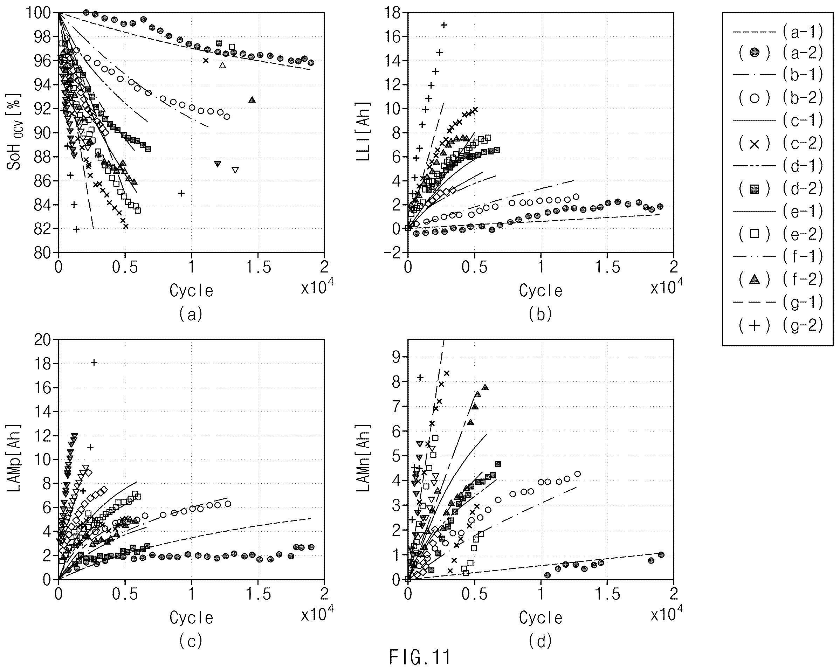

FIG. 10 shows a prediction result in storage degradation in a battery state prediction apparatus according to an embodiment, and FIG. 11 shows a prediction result in cycle degradation in a battery state prediction apparatus according to an embodiment.

In (a) of FIGS. 10 and 11, a horizontal axis may mean a time and a vertical axis may mean a state of health (SOH) of a battery, and in (b) of FIGS. 10 and 11, a horizontal axis may mean a time and a vertical axis may mean an LLI meaning a lithium ion reduction. In (c) of FIGS. 10 and 11, a horizontal axis may mean a time and a vertical axis may mean an LAMp that is a loss of an active material in a cathode, and in (d) of FIGS. 10 and 11, a horizontal axis may mean a time and a vertical axis may mean an LAMn that is a loss of an active material in an anode.

In (a) to (d) of FIGS. 10 and 11, a point expressed with a figure may mean an experiment value obtained according to experiment, and a graph expressed with a line may mean a simulated value obtained by simulation.

In each of (a), (b), (c), and (d) of FIGS. 10 and 11, an experiment value (a-1) that is a point expressed with a figure may mean a result of derived under the same conditions as a simulated value (a-2) that is the graph expressed with the line. An experiment value (b-1) may mean a result derived under the same conditions as a simulated value (b-2).

That is, in FIG. 10, (a-1) and (a-2) may be results derived under the same conditions, (b-1) and (b-2) may be results derived under the same conditions, (c-1) and (c-2) may be results derived under the same conditions, (d-1) and (d-2) may be results derived under the same conditions, and (e-1) and (e-2) may be results derived under the same conditions.

Likewise, in FIG. 11, (a-1) and (a-2) may be results derived under the same conditions, and (b-1) and (b-2), (c-1) and (c-2), (d-1) and (d-2), (e-1) and (e-2), (f-1) and (f-2), and (g-1) and (g-2) may be results derived under the same conditions, respectively.

As such, with the battery state prediction apparatus according to an embodiment, in each of FIGS. 10 and 11, trend lines of results grouped with the same alphabet are obtained with similar profiles, such that theories and assumptions used in the prediction model may be analyzed as valid in real environments.

Specifically, FIG. 10 may include results of predicting an SOH, an LLI, an LAMp, and an LAMn in storage degradation, and FIG. 11 may include results of predicting an SOH, an LLI, an LAMp, and an LAMn in cycle degradation.

First, the battery state prediction apparatus 1 according to an embodiment may improve the accuracy of prediction of an LLI by introducing an acceleration factor that may not be considered in the conventional arts, as shown in (b) of FIG. 10, and may improve the accuracy of prediction of an LAMp by introducing a cation mixing model and a particle cracking induced volume change model that may not be considered in the conventional arts, as shown in (c) of FIG. 10.

Moreover, the battery state prediction apparatus 1 according to an embodiment may improve the accuracy of prediction of an LAMn by considering a correlation between the LLI and the LAMn, which may not be considered in the conventional arts, as shown in (d) of FIG. 10, thereby improving the accuracy of SOH estimation as shown in (a) of FIG. 10.

Next, the battery state prediction apparatus 1 according to an embodiment may model the degradation of a battery by considering cycle degradation, unlike the conventional arts that only consider the storage degradation model as shown in (a) to (d) of FIG. 11.

Accordingly, the battery state prediction apparatus 1 according to an embodiment may have the effect of improving the accuracy and precision of estimating an SOH for predicting the state of the battery, as shown in FIGS. 10 and 11.

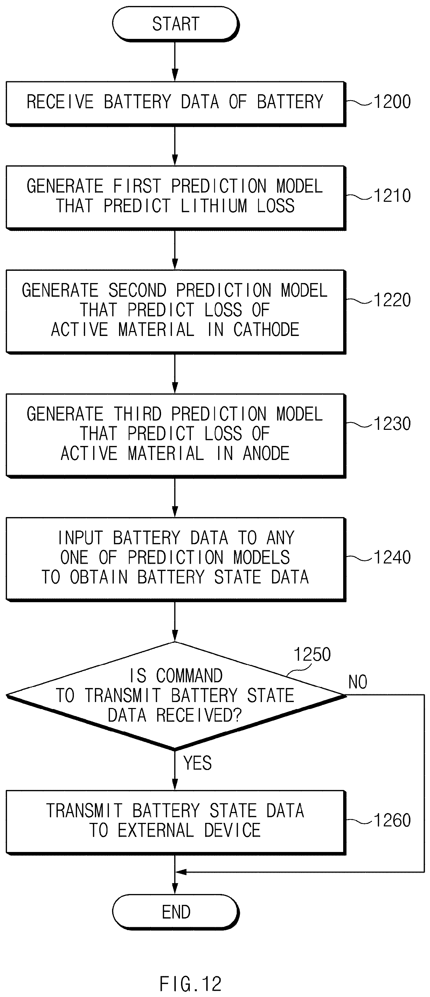

FIG. 12 is a control flowchart of a battery state prediction method according to an embodiment.

Referring to FIG. 12, the at least one processor 110 may receive battery data of a battery in operation 1200. Thereafter, the processor 110 may generate a first prediction model related to an LLI, which predicts a lithium loss, in operation 1210.

The processor 110 may also generate a second prediction model related to an LAMp, which predicts a loss of an active material in a cathode, in operation 1220, and generate a third prediction model related to an LAMn, which predicts a loss of an active material in an anode, in operation 1230.

Here, the processor 110 is described as generating the first to third prediction models, but the first to third prediction models may also mean models that are generated in advance and stored in the memory 120.

Thereafter, the processor 110 may input the battery data into any one of the prediction models to obtain battery state data, in operation 1240. In this case, the processor 110 may input the battery data into any one of the prediction models and input its output value into another prediction model to obtain the battery state data.

Specifically, the processor 110 may input a battery capacity change derived by the first prediction model to the second prediction model or the third prediction model to derive a decay factor, and predict a state of the battery based on the decay factor.

That is, the processor 110 may first calculate a capacity change due to an LLI from the first prediction model and input the same into the second prediction model and the third prediction model to derive the decay factor based on Equations 23 to 26.

Thereafter, the processor 110 may determine whether a command to transmit the battery state data has been received, in operation 1250, and when the processor 110 determines that the command to transmit the battery state data has been received (YES in operation 1250), the processor 110 may transmit the battery state data to the external device 5 in operation 1260.

As such, the battery state prediction apparatus 1 according to an embodiment may predict battery degradation to ensure the stability of battery use, provide an integrated model for reflection in battery warranty, and secure data for analyzing a cause for a battery defect.

Meanwhile, disclosed embodiments may be implemented in the form of a recording medium that stores an instruction executable by a computer. The instruction may be stored in the form of a program code, and, when executed by a processor, may generate a program module and perform operations according to disclosed embodiments. The recording medium may be implemented as a computer-readable recording medium.

The computer-readable recording medium may include any type of recording media that store an instruction interpretable by a computer. For example, the computer-readable recording medium may include read-only memory (ROM), random-access memory (RAM), a magnetic tape, a magnetic disk, flash memory, an optical data storage device, etc.

In addition, the computer-readable recording medium may be provided in the form of a non-transitory storage medium. Herein, the term 'non-transitory storage medium' simply means that the storage medium is a tangible device, and does not include a signal (e.g., an electromagnetic wave), but this term does not differentiate between where data is semi-permanently stored in the storage medium and where the data is temporarily stored in the storage medium. For example, the 'non-transitory storage medium' may include a buffer storing data temporarily.

According to an embodiment of the disclosure, a method according to various embodiments of the disclosure may be included and provided in a computer program product. The computer program product may be traded as a product between a seller and a buyer. The computer program product may be distributed in the form of a machine-readable recording medium (e.g., compact disc read only memory (CD-ROM)), or be distributed (e.g., downloaded or uploaded) online via an application store (e.g., Play Store™), or between two user devices (e.g., smart phones) directly. When distributed online, at least a part of the computer program product (e.g., a downloadable app) may be temporarily generated or at least temporarily stored in the machine-readable recording medium, such as memory of the manufacturer's server, a server of the application store, or a relay server.

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit disclosed herein is not limited by these embodiments. The protection scope of the technical spirit disclosed herein should be interpreted by the following claims, and all technical spirits within the same range should be understood to be included in the range of this document.

**Claims**

1. A battery state prediction apparatus comprising:

    a communication interface configured to receive battery data from a battery; and
    at least one processor configured to generate a battery state prediction model comprising a first prediction model that predicts a loss of lithium, a second prediction model that predicts a loss of an active material in a cathode, and a third prediction model that predicts a loss of an active material in an anode and input the battery data to the battery state prediction model to obtain battery state data.

2. The battery state prediction apparatus of claim 1, wherein the at least one processor is further configured to generate the first prediction model based on an acceleration factor that quantizes a stress applied to an electrode and a solid electrolyte interphase (SEI).

3. The battery state prediction apparatus of claim 2, wherein the at least one processor is further configured to determine a chemical rate change of the active material due to the loss of lithium based on the first prediction model, and determine an open circuit potential (OCP) of the anode and the cathode based on the chemical rate change of the active material.

4. The battery state prediction apparatus of claim 3, wherein the at least one processor is further configured to predict the state of the battery based on a variance of the OCP.

5. The battery state prediction apparatus of claim 1, wherein the at least one processor is further configured to generate the second prediction model based on a cation mixing and a particle cracking induced volume change.

6. The battery state prediction apparatus of claim 5, wherein the at least one processor is further configured to input the battery data to the second prediction model to determine a degradation degree of the battery.

7. The battery state prediction apparatus of claim 1, wherein the at least one processor is further configured to determine a correlation between the loss of lithium and the loss of the active material in the anode and generate the third prediction model based on the correlation.

8. The battery state prediction apparatus of claim 1, wherein the at least one processor is further configured to input a battery capacity change derived by the first prediction model to the second prediction model or the third prediction model to derive a decay factor, and predict the state of the battery based on the decay factor.

9. A battery state prediction method comprising:

receiving battery data from a battery;
generating a battery state prediction model comprising a first prediction model that predicts a loss of lithium, a second prediction model that predicts a loss of an active material in a cathode, and a third prediction model that predicts a loss of an active material in an anode; and
inputting the battery data to the battery state prediction model to obtain battery state data.

10. The battery state prediction method of claim 9, wherein the generating of the first prediction model comprises generating the first prediction model based on an acceleration factor that quantizes a stress applied to an electrode and a solid electrolyte interphase (SEI).

11. The battery state prediction method of claim 10, further comprising determining a chemical rate change of the active material due to the loss of lithium based on the first prediction model, and determine an open circuit potential (OCP) of the cathode and the anode based on the chemical rate change of the active material.

12. The battery state prediction method of claim 11, further comprising predicting the state of the battery based on a variance of the OCP.

13. The battery state prediction method of claim 9, wherein the generating of the second prediction model comprises generating the second prediction model based on a cation mixing and a particle cracking induced volume change.

14. The battery state prediction method of claim 13, further comprising inputting the battery data to the second prediction model to determine a degradation degree of the battery.

15. The battery state prediction method of claim 9, wherein the generating of the third prediction model comprises determining a correlation between the loss of lithium and the loss of the active material in the anode and generate the third prediction model based on the correlation.

16. The battery state prediction method of claim 9, further comprising inputting a battery capacity change derived by the first prediction model to the second prediction model or the third prediction model to derive a decay factor, and predict the state of the battery based on the decay factor.

FIG.1

FIG.2

FIG.3

(a)

$-\cdot-$45oC
$\underline{\quad\quad}$25oC
$------$10oC

(b)

FIG.4

FIG.5

FIG.6

FIG.7

FIG.8

FIG.9

FIG.10

FIG.11

START

RECEIVE BATTERY DATA OF BATTERY —1200

GENERATE FIRST PREDICTION MODEL
THAT PREDICT LITHIUM LOSS —1210

GENERATE SECOND PREDICTION MODEL
THAT PREDICT LOSS OF
ACTIVE MATERIAL IN CATHODE —1220

GENERATE THIRD PREDICTION MODEL
THAT PREDICT LOSS OF
ACTIVE MATERIAL IN ANODE —1230

INPUT BATTERY DATA TO ANY
ONE OF PREDICTION MODELS
TO OBTAIN BATTERY STATE DATA —1240

IS COMMAND
TO TRANSMIT BATTERY STATE
DATA RECEIVED? —1250
NO

YES

TRANSMIT BATTERY STATE DATA
TO EXTERNAL DEVICE —1260

END

FIG.12

## INTERNATIONAL SEARCH REPORT

International application No.

**PCT/KR2024/010866**

### A. CLASSIFICATION OF SUBJECT MATTER

**G01R 31/367**(2019.01)i; **G01R 31/392**(2019.01)i; **G01R 31/36**(2006.01)i; **G01R 31/396**(2019.01)i

According to International Patent Classification (IPC) or to both national classification and IPC

### B. FIELDS SEARCHED

Minimum documentation searched (classification system followed by classification symbols)

G01R 31/367(2019.01); G01R 31/36(2006.01); G01R 31/374(2019.01); G01R 31/389(2019.01); G01R 31/392(2019.01); G01R 31/396(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 상태 예측(battery state prediction), 예측 모델(prediction model), 리튬 손실 (Loss of Lithium Inventory LLI), 활성 물질 손실(Loss of Active Material, LAM)

### C. DOCUMENTS CONSIDERED TO BE RELEVANT

| Category* | Citation of document, with indication, where appropriate, of the relevant passages | Relevant to claim No. |
|---|---|---|
| A | KR 10-2023-0075033 A (SAMSUNG ELECTRONICS CO., LTD.) 31 May 2023 (2023-05-31) See paragraphs [0028]-[0031] and figure 1. | 1-16 |
| A | KR 10-1949449 B1 (SMARTENM) 18 February 2019 (2019-02-18) See paragraph [0024] and figures 3 and 6-10. | 1-16 |
| A | CN 110954832 A (BEIJING JIAOTONG UNIVERSITY) 03 April 2020 (2020-04-03) See claims 1-6 and figures 1-5. | 1-16 |
| A | KR 10-2019-0015991 A (SAMSUNG ELECTRONICS CO., LTD.) 15 February 2019 (2019-02-15) See claims 1-16 and figures 1-9. | 1-16 |
| A | KR 10-2020-0117860 A (SAMSUNG ELECTRONICS CO., LTD.) 14 October 2020 (2020-10-14) See claims 1-16 and figures 1-6. | 1-16 |

☐ Further documents are listed in the continuation of Box C. ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **24 October 2024** | **24 October 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

| International application No. |
|---|
| **PCT/KR2024/010866** |

| Patent document cited in search report | | | Publication date (day/month/year) | Patent family member(s) | | | Publication date (day/month/year) |
|---|---|---|---|---|---|---|---|
| KR | 10-2023-0075033 | A | 31 May 2023 | US | 2023-0160965 | A1 | 25 May 2023 |
| KR | 10-1949449 | B1 | 18 February 2019 | | None | | |
| CN | 110954832 | A | 03 April 2020 | | None | | |
| KR | 10-2019-0015991 | A | 15 February 2019 | KR | 10-2563754 | B1 | 04 August 2023 |
| | | | | US | 10784542 | B2 | 22 September 2020 |
| | | | | US | 2019-0221897 | A1 | 18 July 2019 |
| KR | 10-2020-0117860 | A | 14 October 2020 | US | 11340300 | B2 | 24 May 2022 |
| | | | | US | 2020-0319256 | A1 | 08 October 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230097583

- KR 1020240089939